# EUROPÄISCHE PATENTSCHRIFT

(11) **EP 0 805 985 B1**
(45) Veröffentlichungstag und Bekanntmachung des Hinweises auf die Patenterteilung: **18.07.2001**
(21) Anmeldenummer: 96900245.0
(22) Anmeldetag: 02.01.1996
(51) Int. Cl.: G01P 15/08, G01P 15/125

(54) **MIKROMECHANISCHES BAUELEMENT**
MICROMECHANICAL COMPONENT
COMPOSANT MICROMECANIQUE

(30) Priorität: 24.01.1995 DE 19502115
(43) Veröffentlichungstag der Anmeldung: 12.11.1997
(73) Patentinhaber: Infineon Technologies AG, 81669 München (DE)
(72) Erfinder: BIEBL, Markus, D-86163 Augsburg (DE)
(74) Vertreter: Zedlitz, Peter, Dipl.-Inf.
(86) Internationale Anmeldenummer: DE9600004
(87) Internationale Veröffentlichungsnummer: WO9623230

(56) Entgegenhaltungen:
- EP-A- 0 605 300
- DE-A- 4 315 012
- US-A- 4 999 735
- US-A- 5 258 097
- US-A- 5 313 836

## Beschreibung

Ein grundsätzliches Problem bei der Herstellung und vor allem im Betrieb mikromechanischer Strukturen stellt das Klebenbleiben (Sticking) der beweglichen Teile an den gegenüberliegenden Flächen im Falle großer Auslenkungen dar. Sehr starke intermolekulare Kräfte mit kurzer Reichweite wie die Van-der-Waals-Kraft und Wasserstoffbrückenbindungen führen in diesem Falle zu einer unlösbaren Verbindung zwischen der ausgelenkten mikromechanischen Struktur und der gegenüberliegenden Fläche, was das Bauelement unbrauchbar macht. Dieses Problem tritt insbesondere bei sehr empfindlichen Beschleunigungssensoren mit einem entsprechend weich aufgehängten Masseteil auf, bei denen es bei den auftretenden Beschleunigungen zu einem Haften der mikromechanischen Struktur an dem festen Teil kommen kann. Außerdem tritt das Problem auf, daß dabei ein Kurzschluß zwischen einem als Elektrode verwendeten beweglichen Teil und einer diesem Teil gegenüberliegend angeordneten Elektrode kommen kann, was ebenfalls zur Zerstörung des Bauelementes führt.

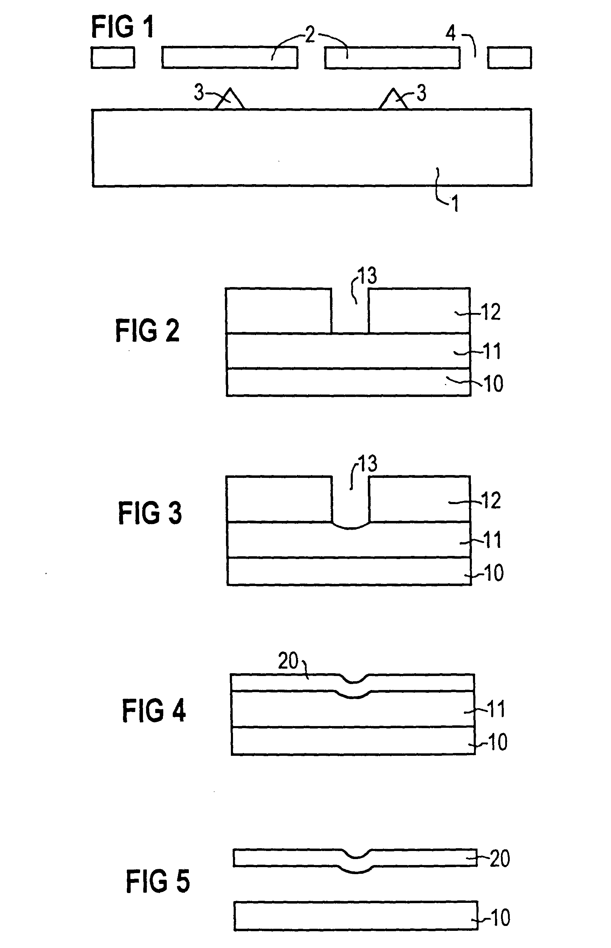

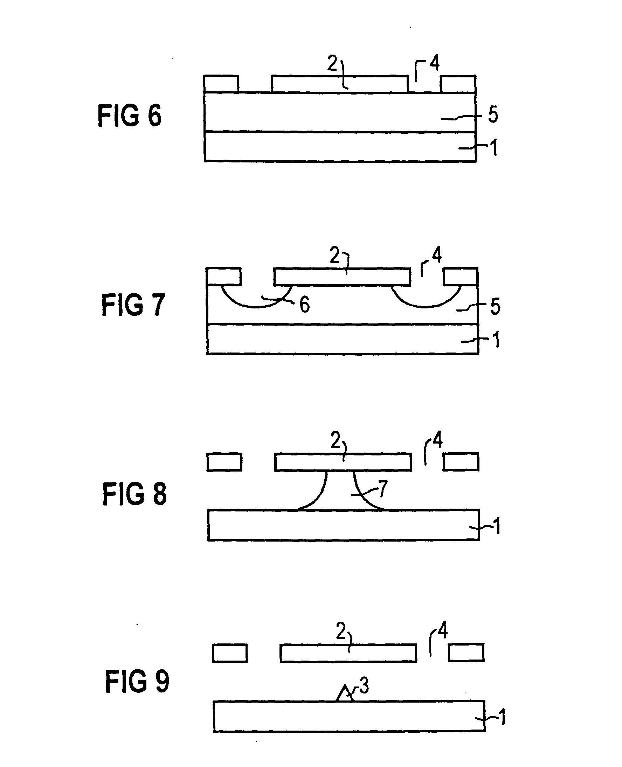

Für die Herstellung mikromechanischer Strukturen sind Verfahren entwickelt worden, die das Haften der beweglichen Strukturen vermeiden. Diese Verfahren lösen aber nicht das Problem, daß dieses Haften auch nach der Herstellung, also während des Betriebs des Bauelementes, auftreten kann. Um das Sticking während des Betriebes zu vermeiden, kann in der Strukturschicht, in der das bewegliche mikromechanische Teil ausgebildet ist, eine Anzahl kleiner Erhebungen in Richtung der gegenüberliegenden Oberfläche hergestellt sein. Damit wird im Falle eines Zusammenstoßes zwischen den gegenüberliegenden Oberflächen die Berührungsfläche sehr klein gehalten. Um diese Struktur herzustellen, bedarf es einer zusätzlichen Fototechnik und eines isotropen (zusätzlichen) Ätzschrittes. In diesen Verfahrensschritten werden Vertiefungen in einer Opferschicht (nachträglich zu entfernende Hilfsschicht) hergestellt. Danach wird die Strukturschicht auf diese Opferschicht konform abgeschieden, so daß die Vertiefungen in der Opferschicht als Erhebungen der Strukturschicht stehenbleiben, wenn die Opferschicht entfernt wird. Dieses Verfahren ist in den Figuren 2 bis 5 dargestellt. Figur 2 zeigt ein Zwischenprodukt des Bauelementes im Querschnitt, bei dem auf ein Substrat 10 eine Opferschicht 11 und darauf eine Maske 12 mit einer Öffnung 13 im Bereich der herzustellenden Vertiefung aufgebracht sind. In Figur 3 ist dargestellt, wie durch die Öffnung 13 hindurch eine Vertiefung in der Opferschicht 11 ausgeätzt wird. Nach dem Entfernen der Maske 12 wird die für das bewegliche Teil vorgesehene Strukturschicht 20 in gleichmäßiger Dicke aufgebracht (s. Figur 4). Nach dem Entfernen der Hilfsschicht 11 erhält man die in Figur 5 dargestellte Struktur, bei der die Strukturschicht 20 auf der dem Substrat 10 zugewandten Seite eine Erhebung aufweist. Die Strukturschicht 20 kann entsprechend dem herzustellenden Sensor strukturiert werden. Dieses Verfahren gestattet es nicht, die Erhebungen auf der Strukturschicht ausreichend hoch und spitz herzustellen. Die Abmessungen der Erhebungen sind nämlich durch das Auflösungsvermögen der hierbei verwendeten Fototechnik und durch die anschließende naßchemische Ätzung nach unten so begrenzt, daß keine schmalen Spitzen hergestellt werden können. Für extrem miniaturisierte mikromechanische Bauelemente ist dieses Verfahren zur Vermeidung des Sticking daher nur sehr eingeschränkt brauchbar. Der Nachteil, daß es im Falle einer Berührung zwischen dem beweglichen Teil und der Substratoberfläche zu einem elektrisch leitenden Kontakt zwischen den Flächen kommt, falls dort Elektroden vorgesehen sind, wird dadurch ebenfalls nicht behoben.

In der DE 43 15 012 A1 ist ein mikromechanisches Bauelement beschrieben, das ein parallel zur Oberfläche eines Substrates bewegliches Element aufweist. Zwischen dem beweglichen Element und dem Substrat sind Schichtanteile eines Materials angeordnet, das von dem Material des beweglichen Elementes verschieden ist. Diese Schichtanteile dienen dem Zweck, das bewegliche Element mit dem Substrat zu verbinden und gestatten keine transversale Beweglichkeit des Elementes an der Position dieser Schichtanteile.

Aufgabe der vorliegenden Erfindung ist es, ein mikromechanisches Bauelement und ein zugehöriges Herstellungsverfahren anzugeben, bei dem das Problem des Haftens (Sticking) bei der Herstellung und beim Betrieb vermieden ist.

Diese Aufgabe wird mit dem Bauelement mit den Merkmalen des Anspruches 1 bzw. mit dem Verfahren mit den Merkmalen des Anspruches 10 gelöst. Weitere Ausgestaltungen ergeben sich aus den abhängigen Ansprüchen.

Ein erfindungsgemäßes Bauelement ist in Figur 1 im Querschnitt dargestellt.
Die Figuren 6 bis 9 zeigen Querschnitte von Zwischenprodukten eines erfindungsgemäßen Bauelementes nach verschiedenen Schritten des Herstellungsverfahrens.
Figuren 10 und 11 zeigen erfindungsgemäße Bauelemente in Aufsicht zur Erläuterung des Herstellungsverfahrens.

Bei dem erfindungsgemäßen Bauelement, wie es als Beispiel in Figur 1 gezeichnet ist, befinden sich zwischen einem beweglichen Teil (einer mikromechanischen Struktur) und einer gegenüberliegenden, bezüglich des Chips, auf dem sich das Bauelement befindet, festen Oberfläche mindestens eine Spitze, vorzugsweise aus einem elektrisch isolierenden Material, die als Abstandshalter verhindert, daß das bewegliche Teil die gegenüberliegende Oberfläche berühren kann. Als Beispiel ist auf einem Substrat 1, z. B. einer Halbleiterscheibe oder einer Halbleiterschichtstruktur oder dergleichen, eine Strukturschicht verankert, in der ein bewegliches Teil 2 ausgebildet ist. In dem beweglichen Teil, das z. B. für einen Beschleunigungssensor vorgesehen sein kann, befinden sich für die Herstellung der Spitzen vorgesehene Ätzöffnungen 4. Auf der Oberfläche des Substrates 1 befinden sich seitlich gegen diese Ätzöffnungen 4 versetzt angeordnete Spitzen 3 oder, allgemein, seitlich schmal begrenzte Schichtanteile, die vorzugsweise aus Dielektrikum sind und die verhindern, daß das bewegliche Teil 2 die Oberfläche des Substrates 1 berühren kann.

Die Wirkungsweise dieser Struktur und besonders vorteilhafte Herstellungsverfahren werden im folgenden anhand der Figuren 6 bis 11 beschrieben. Die Figur 6 zeigt im Querschnitt ein Substrat 1, das z. B. eine Halbleiterscheibe oder eine Halbleiterschichtstruktur oder dergleichen sein kann, auf dem eine Hilfsschicht 5 (Opferschicht, sacrificial layer) und eine für die Herstellung des beweglichen Teiles vorgesehene Strukturschicht 2 übereinander aufgebracht sind. In dieser Strukturschicht 2 werden z. B. mit der üblichen Maskentechnik Öffnungen 4 hergestellt, die als Ätzöffnungen für die nachfolgenden Verfahrensschritte vorgesehen sind. Durch diese Ätzöffnungen 4 hindurch wird, wie in Figur 7 gezeigt, das Material der Hilfsschicht 5 ausgeätzt, so daß sich unter der Strukturschicht 2 im Bereich der Ätzöffnungen 4 die Aussparungen 6 in der Hilfsschicht 5 ergeben. Die Hilfsschicht 5 wird in voller Höhe weggeätzt, so daß im Verlauf des Ätzprozesses die in Figur 8 dargestellte Struktur entsteht, bei der die Strukturschicht 2 nur noch auf einem Restanteil 7 der Hilfsschicht 5 ruht. Durch rechtzeitiges Abbrechen des Ätzvorganges wird erreicht, daß das in der Strukturschicht ausgebildete bewegliche Teil 2 von der Hilfsschicht 5 befreit ist, aber von der Hilfsschicht 5 ein restlicher Schichtanteil 3 als schmale Spitze auf dem Substrat 1 übrigbleibt.

Wenn die Hilfsschicht 5 aus einem dielektrischen Material, z. B. einem Oxid, hergestellt wird, fungieren die hergestellten Spitzen 3 gleichzeitig als Isolator zwischen dem Substrat 1 und dem beweglichen Teil 2, so daß an den einander gegenüberliegenden Oberflächen Elektroden angeordnet sein können, ohne daß ein Kurzschluß bei zu starken Auslenkungen des beweglichen Teiles 2 im Betrieb befürchtet werden muß. Nach der Herstellung dieser Struktur haftet das bewegliche Teil zunächst auf den Spitzen. Nach dem Abtrockenen der noch auf der Oberfläche des Substrates vorhandenen Flüssigkeit genügen aber bereits die elastischen Rückstellkräfte der Aufhängung des beweglichen Teiles, um dieses Teil von den Spitzen 3 abzulösen.

Die als Abstandshalter vorgesehenen Spitzen oder Erhebungen, die in den Ansprüchen einheitlich als Schichtanteile bezeichnet werden, sind auf der dem beweglichen Teil zugewandten Oberseite eines Substrates oder einer bezüglich des Chips festen Schichtstruktur angeordnet. Die Schichtanteile können aus Metall sein, wobei z. B. durch eine zwischen einer für kapazitive Messung vorgesehenen Elektrode am Substrat und diesen Schichtanteilen eine elektrisch isolierende weitere Schicht oder dergleichen vorhanden sein kann. Ein elektrischer Kontakt zwischen Elektroden am Substrat und am beweglichen Teil kann auch dadurch vermieden sein, daß die als Abstandshalter fungierenden Schichtanteile nur dort vorhanden sind, wo die dem Substrat zugewandte Oberfläche des beweglichen Teils oder die dem beweglichen Teil zugewandte Oberfläche des Substrates nur dielektrisches Material aufweist. Die Schichtanteile können daher elektrisch isolierend aus vorzugsweise verwendetem Dielektrikum oder aus Metall sein, falls z. B. höhere mechanische Beanspruchung härtere Schichtanteile erforderlich macht.

Die vorliegende Erfindung läßt sich ausführen bei planaren mikromechanischen Strukturen, aber auch bei gewölbten Strukturen, z. B. bei Beschleunigungssensoren, die zur Feststellung von Rotationsbewegungen oder dergleichen eingesetzt werden. Die Spitzen oder Schichtanteile 3 können sehr niedrig, sehr flach oder sehr spitz ausgebildet werden. Sie können so hoch sein, wie der Abstand zwischen der festen Oberfläche und dem beweglichen Teil in der Ruhelage, um z. B. eine Auslenkung des beweglichen Teiles zum Substrat hin vollständig auszuschließen. Dabei muß nur sichergestellt sein, daß das bewegliche Teil für den Verwendungszweck des Bauelementes in der Bewegungsebene, also in den gezeigten Beispielen parallel zur Substratoberfläche, ausreichend frei beweglich ist. Die oberen Enden der Schichtanteile 3 können spitz zulaufen oder abgeflacht oder verrundet sein. Es genügt, wenn diese Schichtanteile seitlich ausreichend schmal begrenzt sind, so daß die mögliche Berührungsfläche zwischen diesen Schichtanteilen und dem beweglichen Teil für eine Vermeidung des Haftens ausreichend gering ist.

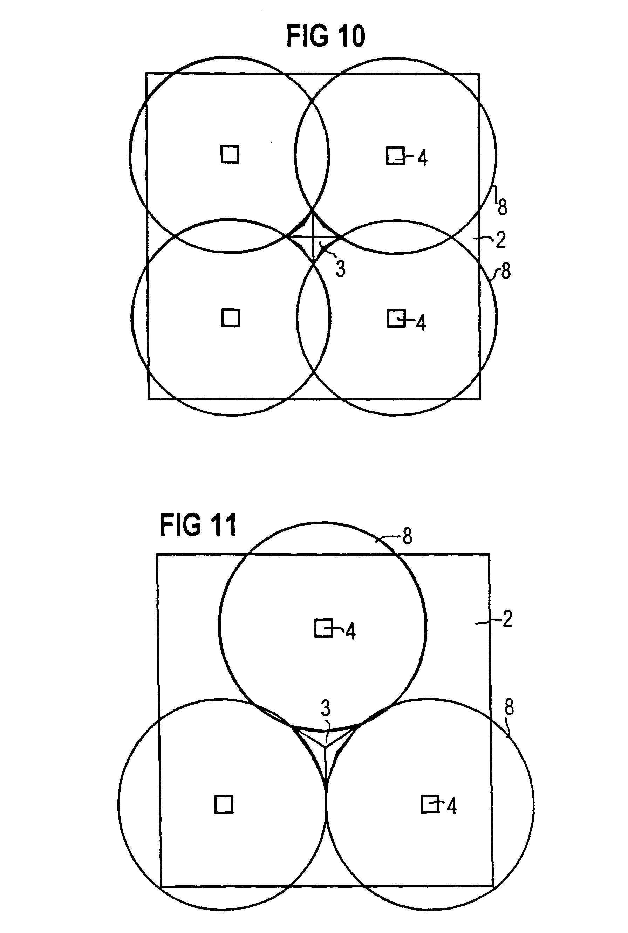

Zweckmäßig ist es, die Ätzöffnungen 4 gleichzeitig mit der Strukturierung der Strukturschicht 2 herzustellen und die Hilfsschicht 5 nachfolgend naßchemisch zu ätzen, wobei das Material der Hilfsschicht 5 so gewählt ist, daß sich die Hilfsschicht 5 selektiv zum Material der Strukturschicht und zum Material der Oberfläche des Substrates 1 ätzen läßt. Beispiele für die Anordnung der Ätzöffnungen 4 sind in den Figuren 10 und 11 gezeichnet. Die Ätzöffnungen sind an den Punkten eines regelmäßigen Gitters angeordnet. Dieses Gitter bildet eine Art Raster, das in zwei verschiedenen Richtungen um eine bestimmte Länge verschoben werden kann und dabei in sich selbst abgebildet wird. Auf diese Weise erhält man eine Anordnung der Ätzöffnungen, bei denen, von den Öffnungen am Rand des strukturierten beweglichen Teiles abgesehen, jede Ätzöffnung von derselben Zahl (größer als zwei) von Ätzöffnungen umgeben ist, die von dieser besagten Ätzöffnung den geringsten Abstand haben. Im Beispiel der Figur 10 ist das Raster ein Quadratgitter, bei dem die Ätzöffnungen 4 jeweils von vier nächstgelegenen Öffnungen in senkrecht aufeinanderstehenden Richtungen umgeben sind. Bei gleichmäßiger Dicke der Hilfsschicht 5 und gleicher Größe der Ätzöffnungen 4 ergibt sich bei örtlich homogener Ätzrate für jede Ätzöffnung der in Figur 10 eingezeichnete kreisförmig berandete Ätzbereich. Durch geeignete Wahl der Ätzdauer wird erreicht, daß der Bereich der Ätzung innerhalb der in Figur 10 eingezeichneten Kreise 8 liegt. Von der ausgeätzten Hilfsschicht 5 bleibt dann in der Mitte ein restlicher Schichtanteil 3, der die herzustellende Spitze bildet. Wegen der sich bei der Ätzung ergebenden schrägen Flanken dieses verbleibenden Schichtanteiles ist das resultierende Gebilde etwa einer Pyramide mit gewölbten Seitenflächen ähnlich.

Bei der Anordnung der Ätzlöcher entsprechend Figur 11 bilden die drei eingezeichneten Ätzöffnungen ein gleichseitiges Dreieck. Es handelt sich also um ein Sechseckraster oder ein mathematisches Gitter, bei dem die Richtungen der Geraden, auf denen die benachbarten Gitterpunkte angeordnet sind, Winkel von 60° zueinander bilden. Jede Ätzöffnung, die nicht am Rand liegt, ist dann von sechs nächstbenachbarten Ätzöffnungen umgeben. Bei wiederum gleichmäßiger Dicke der Hilfsschicht 5 und gleich großen Ätzöffnungen ergeben sich bei örtlich homogener Ätzrate und passend gewählter Ätzdauer die in der Figur 11 als Kreise 8 eingezeichneten Ätzbereiche. In diesem Fall bleibt als restlicher Schichtanteil 3 der Hilfsschicht 5 ein Gebilde, das einem Tetraeder mit gewölbten Seitenflächen ähnelt. Wenn die einander nächstgelegenen Ätzöffnungen 4 anders zueinander ausgerichtet sind, können beim Ätzen Schichtanteile 3 entstehen, die z. B. eine eher längliche Form aufweisen. Bei der Anordnung der Figur 10 können z. B. die benachbarten Ätzöffnungen in der Waagrechten der Zeichenebene einen größeren oder kleineren Abstand voneinander haben als die benachbarten Ätzöffnungen senkrecht zu dieser Richtung. Nach allen Seiten sehr schmal begrenzte Spitzen erhält man, wenn von der Position der Spitze aus gesehen ringsum viele Ätzöffnungen vorhanden sind, die von dieser Spitze denselben Abstand haben, wenn das bewegliche Teil in die Position gebracht wird, die es auch während des Ätzvorganges eingenommen hat, wie z. B. eine Ruheposition oder Normalposition. Die Ätzöffnungen werden allgemein vorzugsweise auf den Eckpunkten regelmäßiger Vielecke, die einander nicht überschneiden (überschneidungsfreie Parkettierung der Ebene), angeordnet, so daß man nach allen Seiten etwa gleichmäßig eng begrenzte Spitzen beim Ätzen erhält. Wenn diese Vielecke zusätzlich Teil eines Gitters oder Rasters sind (vollständige Parkettierung mit gleichen Vielecken), kann jede nicht am Rand des beweglichen Teiles angeordnete Ätzöffnung gleichzeitig dem Ätzen mehrerer Spitzen dienen. Es ist aber grundsätzlich möglich, die Zahl und Anordnung der Ätzöffnungen in geeigneter Weise an die Form der herzustellenden beweglichen Struktur und die jeweiligen Herstellungsbedingungen anzupassen.

Die als Abstandshalter dienenden Schichtanteile können mit diesem Verfahren besonders schmal und spitz ausgebildet werden, so daß die bei dem erfindungsgemäßen Bauelement vorhandene Struktur so hergestellt werden kann, daß ein Sticking nachhaltig vermieden ist. Wegen der möglichen Verwendung eines Dielektrikums für diese Schichtanteile wird außerdem eine elektrische Isolation der beweglichen Struktur von dem Rest des Chips erreicht.

## Patentansprüche

1. Mikromechanisches Bauelement mit einem Substrat (1) und mit einem parallel zur Oberseite des Substrates beweglichen Teil (2), das in einem Abstand über dem Substrat (1) angeordnet ist,
bei dem auf einer bezüglich dieses Substrates festen Oberfläche dieses Bauelementes, die diesem beweglichen Teil zugewandt ist, mindestens ein Schichtanteil (3) aus einem Material, das von dem Material des beweglichen Teils verschieden ist, vorhanden ist,
bei dem dieser Schichtanteil sich in Richtung zu dem beweglichen Teil hin so stark verjüngt, daß die Beweglichkeit des beweglichen Teiles nur senkrecht zur Oberseite des Substrates eingeschränkt ist, und
bei dem das obere Ende des Schichtanteils (3) spitz zuläuft oder abgeflacht oder verrundet ist und begrenzt wird von einer vieleckigen Grundfläche und ebenen oder gewölbten Dreiekken, die durch je eine Seite dieser Grundfläche und eine dieser Grundfläche gegenüberliegende und allen diesen Dreiecken gemeinsame Ecke gegeben sind.

2. Mikromechanisches Bauelement nach Anspruch 1,
bei dem der Schichtanteil (3) aus Dielektrikum besteht und zwischen Oberflächen angeordnet ist, die elektrisch leitend sind.

3. Mikromechanisches Bauelement nach einem der Ansprüche 1 oder 2,
bei dem das bewegliche Teil (2) ein schichtartig ausgebildetes Masseteil eines Sensors ist.

4. Mikromechanisches Bauelement nach einem der Ansprüche 1 bis 3 mit mehreren Schichtanteilen gemäß Anspruch 1,
bei dem das bewegliche Teil (2) Aussparungen (4) aufweist, die jeweils einander gegenüberliegende Oberflächen des beweglichen Teiles schneiden, und
bei dem diese Aussparungen (4) so angeordnet sind, daß eine Position des beweglichen Teiles existiert, in der diese Aussparungen (4) etwa gleiche Abstände von den jeweils nächstgelegenen Schichtanteilen haben.

5. Mikromechanisches Bauelement nach einem der Ansprüche 1 bis 4,
bei dem Schichtanteile (3) an Punkten eines flächigen Rasters (Gitters) angeordnet sind, das so beschaffen ist, daß es in mindestens zwei nicht zueinander parallelen Richtungen durch beliebige Vielfache einer jeweiligen abstandserhaltenden (orthogonalen) Abbildung auf sich selbst abgebildet werden kann.

6. Mikromechanisches Bauelement nach einem der Ansprüche 1 bis 5,
bei dem Schichtanteile (3) so angeordnet sind, daß für jeden nicht am Rand dieser Strukturschicht gelegenen Schichtanteil die Anzahl derjenigen Schichtanteile, die von diesem besagten Schichtanteil den geringsten Abstand haben, gleich und größer als zwei ist.

7. Mikromechanisches Bauelement nach einem der Ansprüche 1 bis 6,
bei dem Schichtanteile (3) an den Eckpunkten gleich großer regelmäßiger Vielecke angeordnet sind, die zu einer überschneidungsfreien Überdeckung (Parkettierung) einer Fläche gehören.

8. Verfahren zur Herstellung eines Bauelementes nach einem der Ansprüche 1 bis 7, bei dem
a) auf eine bezüglich des Substrates (1) feste Oberfläche eine Hilfsschicht (5) aus einem Material, das bezüglich des Materials dieser Oberfläche selektiv entfernt werden kann, aufgebracht wird,
b) auf diese Hilfsschicht (5) eine zur Herstellung des beweglichen Teiles vorgesehene Strukturschicht (2) aus einem Material, bezüglich dessen das Material dieser Hilfsschicht selektiv entfernt werden kann, aufgebracht wird,
c) diese Strukturschicht mit Aussparungen (4) versehen wird, die jeweils Oberflächen auf einander gegenüberliegenden Seiten der Strukturschicht schneiden, und
d) unter Verwendung dieser Aussparungen (4) als Ätzöffnungen das Material der Hilfsschicht soweit entfernt wird, daß Schichtanteile (3) vorgesehener Abmessungen auf der bezüglich des Substrates festen Oberfläche stehenbleiben.

## Claims

1. Micromechanical component having a substrate (1) and a part (2) which is movable parallel to the top of the substrate and which is disposed at a distance above the substrate (1) wherein at least one layer component (3) composed of a material which is different from the material of the movable part is present on a surface of the said component, which surface is fixed with respect to the said substrate and is adjacent to the said movable part, wherein the said layer component tapers so severely in the direction of the movable part that the mobility of the movable part is restricted only perpendicularly to the top of the substrate, and wherein the upper end of the layer component (3) tapers to a point or is flattened or rounded and is bounded by a polygonal basal face and flat or arched triangles which are each formed by one side of the said basal face and a corner which is situated opposite the said basal face and is common to all the the said triangles.

2. Micromechanical component according to Claim 1, wherein the layer component (3) is composed of dielectric and is disposed between surfaces which are electrically conducting.

3. Micromechanical component according to either of Claims 1 or 2, wherein the movable part (2) is an inertial part formed in layer fashion in a sensor.

4. Micromechanical component according to any one of Claims 1 to 3, having a plurality of layer components according to Claim 1, wherein the movable part (2) has apertures (4) which each intersect mutually oppositely situated surfaces of the movable part, and wherein the said apertures (4) are disposed so that a position of the movable part exists in which the said apertures (4) are at roughly equal distances from the respectively immediately adjacent layer components.

5. Micromechanical component according to any one of Claims 1 to 4, wherein layer components (3) are disposed at points in a two-dimensional array (grid) which is such that it can be imaged on itself in at least two directions, which are not mutually parallel, by any multiple of a respective space-maintaining (orthogonal) image.

6. Micromechanical component according to any one of Claims 1 to 5, wherein layer components (3) are disposed so that, for any layer component not situated at the periphery of the said layer structure, the number of those layer components which are at the smallest distance from this the said layer component is equal and greater than two.

7. Micromechanical component according to any one of Claims 1 to 6, wherein layer components (3) are disposed at the corner points of equally large, regular polygons which are part of an overlap-free covering (parqueting) of a surface.

8. Method for the production of a component according to any one of Claims 1 to 7, wherein
a) an auxiliary layer (5) composed of a material which can be removed selectively with respect to the material of the said surface is applied to a surface which is fixed with respect to the substrate (1),
b) a structural layer (2) which is provided for the production of the movable part and which is composed of a material with respect to which the material of the said auxiliary layer can be selectively removed is applied to the said auxiliary layer (5),
c) the said structural layer is provided with apertures (4) which each intersect surfaces on mutually opposite sides of the structural layer, and
d) with the said apertures (4) being used as etching apertures, the material of the auxiliary layer is removed to such an extent that layer components (3) of planned dimensions are left on the surface which is fixed with respect to the substrate.

## Revendications

1. Composant micromécanique comportant un substrat (1) et comportant une pièce (2) qui est mobile parallèlement à la face supérieure de substrat et qui est disposée à distance au-dessus du substrat (1),
dans lequel il est présent sur une surface de ce composant, qui est fixe par rapport à ce substrat et qui est tournée vers cette pièce mobile, au moins une partie (3) de couche en un matériau qui est différent du matériau de la pièce mobile,
dans lequel cette partie de couche se réduit en direction de la pièce mobile si fortement que la mobilité de la pièce mobile n'est restreinte que perpendiculairement à la face supérieure du substrat, et
dans lequel l'extrémité supérieure de la partie (3) de couche se termine en pointe ou est aplatie ou est arrondie et est délimitée par une surface de base polygonale et des triangles plans ou incurvés qui sont donnés par chaque fois un côté de cette surface de base et un sommet faisant face à cette surface de base et commun à tous ces triangles.

2. Composant micromécanique suivant la revendication 1, dans lequel la partie (3) de couche est en diélectrique et est disposée entre des surfaces qui sont conductrices de l'électricité.

3. Composant micromécanique suivant une des revendications 1 ou 2, dans lequel la pièce (2) mobile est une partie de masse d'un capteur réalisée de manière stratifiée.

4. Composant micromécanique suivant l'une des revendications 1 à 3, comportant plusieurs parties de couche suivant la revendication 1,
dans lequel la pièce (2) mobile comporte des évidements (4) qui coupent chaque fois des surfaces qui se font face l'une à l'autre de la pièce mobile, et
dans lequel ces évidements (4) sont ménagés de telle manière qu'il existe une position de la pièce mobile dans laquelle ces évidements (4) sont à peu près à des distances identiques des parties de couche ménagées au plus près.

5. Composant micromécanique suivant l'une des revendications 1 à 4,
dans lequel des parties (3) de couche sont ménagées aux points d'un réseau (quadrillage) plat, qui est tel qu'il peut se reproduire de soi-même dans au moins deux directions qui ne sont pas parallèles l'une à l'autre par des multiples quelconques d'une reproduction (orthogonale) maintenant l'écartement.

6. Composant micromécanique suivant l'une des revendications 1 à 5, dans lequel les parties (3) de couche sont ménagées de telle manière que, pour chaque partie de couche qui n'est pas ménagée au bord de cette couche de structure, le nombre des parties de couche qui ont la plus petite distance par rapport à cette partie de couche précitée est égal et supérieur à 2.

7. Composant micromécanique suivant l'une des revendications 1 à 6, dans lequel des parties (3) de couche sont ménagées aux sommets de polygones réguliers de même dimension, qui font partie d'un revêtement sans recoupement (parquetage) d'une surface.

8. Procédé de fabrication d'un composant suivant l'une des revendications 1 à 7, dans lequel
a) on dépose sur une surface fixe par rapport au substrat (1) une couche (5) auxiliaire en un matériau qui peut être enlevé de manière sélective par rapport au matériau de cette surface,
b) on dépose sur cette couche (5) auxiliaire une couche (2) de structure, prévue pour la fabrication de la pièce mobile, en un matériau par rapport auquel le matériau de cette couche auxiliaire peut être enlevé de manière sélective,
c) on munit cette couche de structure d'évidements (4) qui coupent chaque fois des surfaces sur des côtés qui se font face de la couche de structure, et
d) en utilisant ces évidements (4) comme ouvertures pour attaque chimique, on enlève le matériau de la couche auxiliaire jusqu'à ce qu'il reste des parties (3) de couche de dimension prévue sur la surface qui est fixe par rapport au substrat.
